## Europäisches Patentamt

## European Patent Office

## Office européen des brevets

(19)

(11) Numéro de publication: **0 060 188**
**B1**

(12)

# FASCICULE DE BREVET EUROPEEN

(45) Date de publication du fascicule du brevet:
**14.11.84**

(51) Int. Cl.³: **H 03 G 9/02**

(21) Numéro de dépôt: **82400358.6**

(22) Date de dépôt: **02.03.82**

(54) **Circuit de commande de volume et de tonalité incorporant une correction physiologique sans filtre supplémentaire.**

(30) Priorité: **13.03.81 FR 8105128**

(43) Date de publication de la demande:
**15.09.82 Bulletin 82/37**

(45) Mention de la délivrance du brevet:
**14.11.84 Bulletin 84/46**

(84) Etats contractants désignés:
**DE FR GB IT**

(56) Documents cités:
**DE - A - 2 429 242**
**US - A - 4 045 748**
**US - A - 4 076 959**

**RADIO FERNSEHEN ELEKTRONIK, vol. 28, no. 12, décembre 1979, BERLIN (DE) P. EDELMANN: "Integrierte Lautstärke und Klangeinsteller A273 und A274", pages 751-757**

(73) Titulaire: **THOMSON-CSF, 173, Boulevard Haussmann, F-75379 Paris Cedex 08 (FR)**

(72) Inventeur: **Rufray, Jean-Claude, THOMSON-CSF SCPI 173, bld Haussmann, F-75360 Paris Cedex 08 (FR)**
Inventeur: **Imbert, Michel, THOMSON-CSF SCPI 173, bld Haussmann, F-75360 Paris Cedex 08 (FR)**

(74) Mandataire: **Guérin, Michel et al, THOMSON-CSF SCPI 173, Bld Haussmann, F-75379 Paris Cédex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

# Description

La présente invention concerne un circuit de filtrage réalisant la commande de volume et de tonalité d'un amplificateur de signaux à fréquences sonores, notamment un amplificateur destiné à la reproduction de sons en haute fidélité.

Tous les amplificateurs de ce type comportent un bouton de réglage de volume sonore et au moins un bouton de réglage de tonalité, le plus souvent des boutons de réglage séparés pour renforcer les fréquences basses (sons graves) et les fréquences élevées (sons aigus).

Les boutons de réglage agissent sur les gains d'amplificateurs, ou les coefficients d'atténuation d'atténuateurs, qui travaillent dans des bandes de fréquence déterminées: par exemple, le bouton de réglage de volume peut agir sur le gain d'un amplificateur large bande, tandis que les boutons de réglage des graves et des aigus agissent chacun sur le gain ou la bande passante d'un filtre respectif de fréquences basses ou élevées, ou d'un amplificateur ou d'un atténuateur en amont ou en aval de ce filtre.

Par ailleurs, on connaît un phénomène physiologique de l'oreille humaine, phénomène auquel la présente invention s'intéresse plus particulièrement, selon lequel, à faible niveau sonore, l'oreille enregistre moins bien les fréquences moyennes. Autrement dit, si l'on veut entendre à faible niveau le même spectre sonore qu'à niveau normal ou élevé, il est nécessaire de corriger le spectre de fréquences restitué par l'amplificateur en augmentant artificiellement le gain de ce dernier aux fréquences élevées et aux fréquences basses. Cela permet notamment à l'utilisateur, qui a réglé les boutons de tonalité à sa convenance pour un niveau sonore donné, de ne pas être obligé de refaire un réglage s'il modifie le réglage du bouton de volume sonore.

Ce phénomène bien connu a donc donné lieu à l'incorporation dans les appareils de reproduction sonore haute fidélité d'une correction dite correction physiologique, qui est constituée par un filtre en série avec l'amplificateur ou en contre-réaction sur celui-ci, ce filtre ayant pour fonction de provoquer un relèvement des amplitudes des fréquences basses et élevées et pouvant être mis en service ou éliminé à volonté par un commutateur; l'utilisateur peut ainsi introduire la correction physiologique chaque fois que le niveau sonore d'écoute est faible. Cette disposition nécessite donc un filtre spécifique et, le plus souvent, un deuxième potentiomètre couplé à celui du réglage de volume sonore, et cela pour les deux voies stéréophoniques.

La présente invention a pour but la réalisation d'un circuit de filtrage réalisant la commande de volume et de tonalité d'un amplificateur haute fidélité, qui incorpore une correction physiologique d'autant plus importante que le volume sonore est réglé à un niveau plus faible, afin que le relèvement des fréquences basses et élevées, moins bien perçues par l'oreille à faible niveau, se fasse progressivement à mesure que le niveau baisse et soit nul au-dessus d'un certain niveau sonore, cela sans nécessiter aucun filtre particulier autre que les filtres de fréquences basses et élevées associés aux boutons de réglage de tonalité.

Un autre but de l'invention est de prévoir un circuit de filtrage avec réglage de tonalité, réglage de volume et de correction physiologique, dans lequel la mise en service de la correction physiologique n'influe pas, ou influe seulement dans la mesure désirée, sur le niveau sonore global moyen réglé par le bouton de réglage de volume, et de plus n'influe pas, s'il s'agit d'un amplificateur en stéréophonie, sur le réglage de l'équilibrage de niveau des deux voies de signal indépendantes.

Pour atteindre ces buts, la présente invention propose de réaliser un circuit de filtrage qui comprend trois ensembles en parallèle d'un potentiomètre électronique et d'un filtre, constituant trois voies de signal, respectivement aiguë, médium et grave, et un circuit de commande apte à produire des tensions de commande du gain de chacun des potentiomètres électroniques en fonction de la position des boutons de réglage de volume et de tonalité, de manière que les tensions de commande varient toutes trois dans le même sens lorsque le bouton de réglage de volume est actionné, et qu'elles varient différemment selon l'actionnement du ou des boutons de réglage de tonalité; plus précisément, les tensions de commande produites sont telles que la variation du gain du potentiomètre électronique de la voie grave et de celui de la voie aiguë, résultant de l'actionnement du bouton de réglage de volume, soit inférieure à la variation du gain de la voie médium; la diminution ou l'augmentation de gain des potentiomètres électroniques en fonction de l'actionnement du bouton de réglage de volume est au contraire sensiblement la même pour les trois voies au-dessus d'un réglage de niveau sonore donné, ou tout au moins vers la position correspondant au réglage maximal du volume.

On n'a considéré dans cette définition qu'un amplificateur fonctionnant en monophonie. L'invention s'applique tout à fait de la même manière dans le cas d'un amplificateur à deux voies stéréophoniques ou plus, dans lequel on aura alors deux fois trois voies de signal: on doit seulement prévoir en outre un bouton de réglage de balance (équilibrage des deux voies) qui, lui aussi, agit sur le circuit de commande pour lui faire modifier les trois tensions de commande des trois potentiomètres électroniques de chaque voie. En pratique, dans ce cas, les tensions de commande sont des différences de potentiel dans lesquelles un potentiel commun provient du réglage du bouton de commande d'équilibrage; on verra que, grâce à cela, on peut se contenter de prévoir un circuit de commande ayant des boutons de réglage de volume et de tonalité communs aux deux voies stéréophoniques, à moins évidemment qu'on ne préfère des boutons de commande entièrement séparés pour la voie gauche et la voie droite.

Le circuit de filtrage selon l'invention est particulièrement applicable aux amplificateurs possédant une télécommande de réglage de volume, de tonalité, d'équilibrage, etc. En effet, on prévoit généralement des potentiomètres électroniques dans ces amplificateurs pour effectuer les réglages à distance, et il est spécialement intéressant d'utiliser ces potentiomètres électroniques pour introduire la correction physiologique de la manière préconisée par la présente invention.

En pratique, le circuit de filtrage comprend un atténuateur recevant une tension issue du bouton de réglage de volume et reproduisant une tension variant dans le même sens que le volume, cette tension servant à alimenter deux autres atténuateurs recevant respectivement deux tensions issues du ou des boutons de réglage de tonalité, avec en outre un étage de production d'un courant de correction physiologique lié à la position du bouton de réglage de volume, et un moyen pour combiner la tension de sortie de chacun des deux autres atténuateurs et le courant de correction physiologique, et pour produire ainsi deux tensions de commande modifiées par le courant de correction physiologique et destinées à la commande des potentiomètres électroniques des voies grave et aiguë. Les tensions de sortie des atténuateurs sont combinées au courant de correction physiologique dans un sens tel que les tensions de commande ainsi produites pour les potentiomètres électroniques produisent une variation du gain des voies basse et aiguë (en fonction d'une variation de réglage du volume sonore) plus faible que la variation correspondante de la voie médium (qui, elle, subit une variation directement fonction du réglage du volume, sans qu'il y ait de modification par le courant de correction physiologique).

L'étage de production d'un courant de correction physiologique comprend un amplificateur différentiel dont une entrée reçoit une tension de référence et l'autre une tension issue du bouton de réglage du volume sonore, et dont la sortie fournit un courant fonction de la différence des tensions d'entrée, un étage de recopie de ce courant étant prévu pour fournir un courant de correction de la tension de commande des potentiomètres électroniques des voies grave et aiguë.

D'autres caractéristiques et avantages de l'invention apparaîtront à la lecture de la description détaillée qui suit et qui est faite en référence aux dessins annexés dans lesquels:

la fig. 1 représente un schéma simple connu de potentiomètre électronique;

la fig. 2 représente un schéma synoptique de l'amplificateur de fréquences sonores incorporant le circuit de la présente invention;

la fig. 3 représente un schéma du circuit de commande des potentiomètres électroniques des voies grave, aiguë et médium, avec également le circuit d'équilibrage des voies stéréophoniques, et

la fig. 4 représente un schéma détaillé de l'étage de production d'un courant de correction physiologique.

Avant de décrire les circuits spécifiques de la présente invention, on peut rappeler sommairement qu'un potentiomètre électronique, particulièrement utilisé lorsqu'on veut une commande à distance d'atténuation, est un étage atténuateur (ou amplificateur) dont l'atténuation ou le gain peut être commandé(e) par une tension de commande.

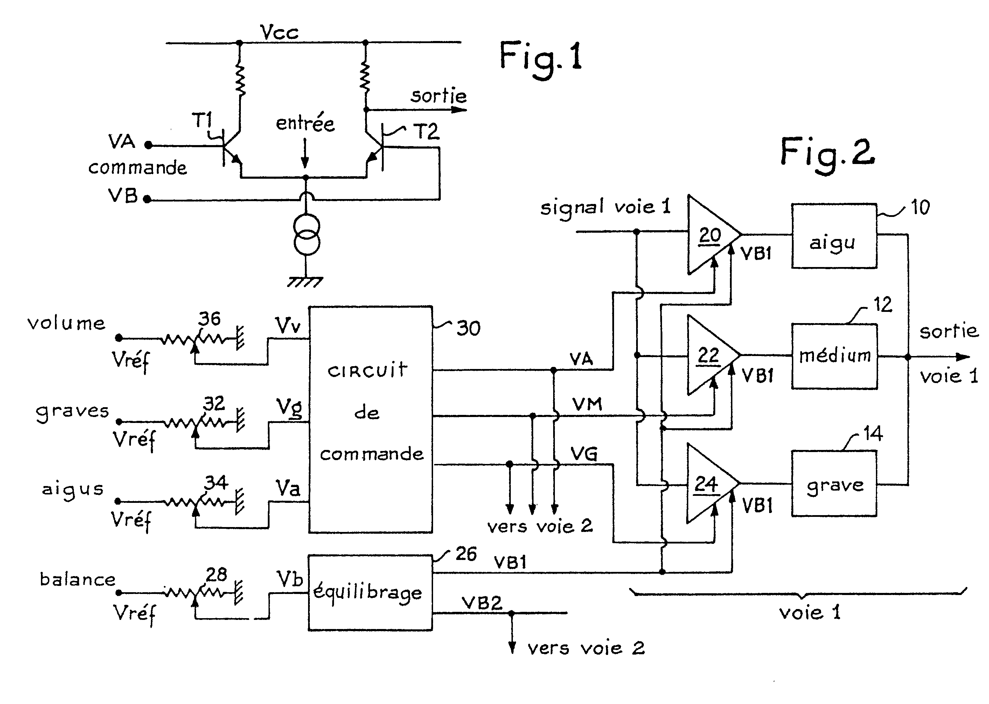

Par exemple, un potentiomètre électronique représenté à la fig. 1 consiste en un étage différentiel à deux transistors $T_1$, $T_2$ dont la tension de commande $VA-VB$ est la différence de potentiel appliquée entre les bases des deux transistors; la sortie se fait sur l'un des collecteurs des transistors, et l'entrée sur les émetteurs alimentés par une source de courant. Un tel étage a d'ailleurs une courbe de réponse exponentielle, la sortie du potentiomètre électronique variant avec la tension de commande selon une fonction exponentielle.

On notera d'ailleurs que ce montage permet de commander le gain en fonction d'une différence de deux tensions variant éventuellement indépendamment l'une de l'autre. On utilisera cette propriété notamment dans le cas d'un amplificateur stéréophonique où le bouton d'équilibrage des deux voies stéréophoniques agira pour produire deux tensions variant en sens inverse, tensions qui seront dirigées respectivement vers la voie gauche et la voie droite et qui serviront chacune de référence variable en fonction de l'équilibrage, tandis que la tension de commande proprement dite de chaque potentiomètre électronique sera issue des boutons de commande de tonalité.

En d'autres mots, le bouton d'équilibrage des voies stéréophoniques produit sur chaque voie une tension variable appliquée à la base de l'un des transistors de chaque potentiomètre électronique, l'autre transistor étant attaqué par la tension de commande appropriée produite en fonction de la position du ou des boutons de réglage de tonalité de l'amplificateur.

Le schéma bloc de l'amplificateur incorporant la présente invention est représenté à la fig. 2.

Il comprend par exemple deux voies stéréophoniques, mais une seule est représentée complètement sur la fig. 2.

Chaque voie comprend trois filtres définissant des bandes de fréquence distinctes pour le filtrage du signal à amplifier, par exemple un filtre d'aigus 10, laissant passer les hautes fréquences, un filtre de médiums 12 pour les fréquences moyennes et un filtre de graves 14 pour le passage des basses fréquences.

Sur la fig. 2, chaque filtre est en série avec un potentiomètre électronique, respectivement 20, 22, 24 qui règle le niveau de signal dans chaque bande de fréquences, et les ensembles en série sont placés tous trois en parallèle, définissant trois voies de signal à fréquences différentes pour chaque voie stéréophonique.

D'autres dispositions générales peuvent d'ailleurs être adoptées sans sortir du cadre de la présente invention. Par exemple, bien que sur la fig. 1 on ait placé les filtres en aval des potentiomètres, ils peuvent aussi être en amont.

Chacun des potentiomètres électroniques est commandé par deux tensions et son gain est une fonction qui sera en général exponentielle (mais qui peut être différente) de la différence de ces tensions. L'une de ces deux tensions, VB1, est commune aux trois potentiomètres de la première voie stéréophonique (voie 1), mais elle est différente de la tension analogue VB2, qui est appliquée en commun aux trois potentiomètres électroniques non représentés de la deuxième voie; les tensions VB1 et VB2, qui varient toujours en sens inverse, sont issues d'un circuit d'équilibrage 26 qui est commandé par un bouton de réglage de l'équilibrage des voies stéréophoniques (schématisé par un potentiomètre à curseur 28 alimenté par une tension de référence Vréf).

Chaque potentiomètre 20, 22, 24 est par ailleurs commandé par une autre tension, respectivement VA pour le potentiomètre 20 de commande des aigus, VM pour le potentiomètre 22 de commande des médiums, et VG pour le potentiomètre 24 de commande des graves. On peut noter que ces trois tensions servent telles quelles aussi à la commande des potentiomètres de la deuxième voie stéréophonique car on veut un même réglage de tonalité sur les deux voies.

Les tensions VA, VM et VG de commande des gains de potentiomètres électroniques sont produites par un circuit de commande 30 en fonction du réglage de volume sonore et de tonalité désiré; plus précisément, le réglage du volume sonore agira par l'intermédiaire du circuit de commande 30 pour faire varier dans le même sens les trois tensions de commande VA, VM et VG afin de les augmenter toutes si le niveau sonore doit augmenter, et de les diminuer toutes si le niveau sonore doit baisser. Au contraire, le réglage de tonalité agira par l'intermédiaire du circuit de commande 30 pour faire varier différemment les tensions VA, VM et VG afin de modifier l'importance relative des fréquences graves, médiums ou aiguës dans le signal de sortie, selon le réglage de tonalité désiré. Dans l'exemple décrit plus précisément ici, on prévoit un bouton de réglage des graves (représenté schématiquement par un potentiomètre à curseur 32 alimenté par la tension de référence Vréf) et un bouton de réglage des aigus (potentiomètre à curseur 34 alimenté par Vréf). L'action sur le bouton de réglage des graves fait directement varier une tension Vg qui, appliquée au circuit de commande 30, fait varier la tension VG; l'action sur le bouton de réglage des aigus fait directement varier une tension Va qui, appliquée au circuit de commande 30, fait varier VA.

VA, VM et VG varient, d'autre part, toutes trois dans le même sens en fonction d'un bouton de réglage de volume représenté schématiquement par un potentiomètre à curseur 36 alimenté par la tension de référence Vréf: ce potentiomètre 36 fait directement varier une tension Vv qui, appliquée au circuit de commande 30, fait varier dans le même sens VA, VG et VM.

Le but de l'invention est de prévoir un circuit de commande 30 particulier qui incorpore une correction physiologique de la courbe de réponse en fréquence de l'amplificateur, de sorte que, pour un réglage donné des boutons de commande de tonalité (potentiomètres à curseurs de graves et d'aigus 32 et 34), la courbe de réponse en fréquence est plus creusée dans les médiums, lorsque le volume sonore est diminué par le bouton de réglage de volume sonore 36, qu'elle ne l'est au maximum du volume sonore.

Par conséquent, le rôle du circuit de commande sera de produire des tensions VA, VM et VG qui ne varieront pas de manière identique (bien que toutes trois dans le même sens) lorsque le bouton de volume sonore sera actionné sans modification des réglages de tonalité: VA et VG varieront moins que VM pour une variation donnée du réglage de volume sonore, tout au moins au-dessous d'un certain niveau de réglage de volume; en pratique, c'est seulement aux alentours du réglage de volume maximal que les tensions VA, VM et VG varieront identiquement, les variations différentes se produisant dès que l'on commence à baisser le volume; cependant, on peut aussi prévoir que la correction physiologique n'intervient qu'au-dessous d'un niveau de réglage donné du volume.

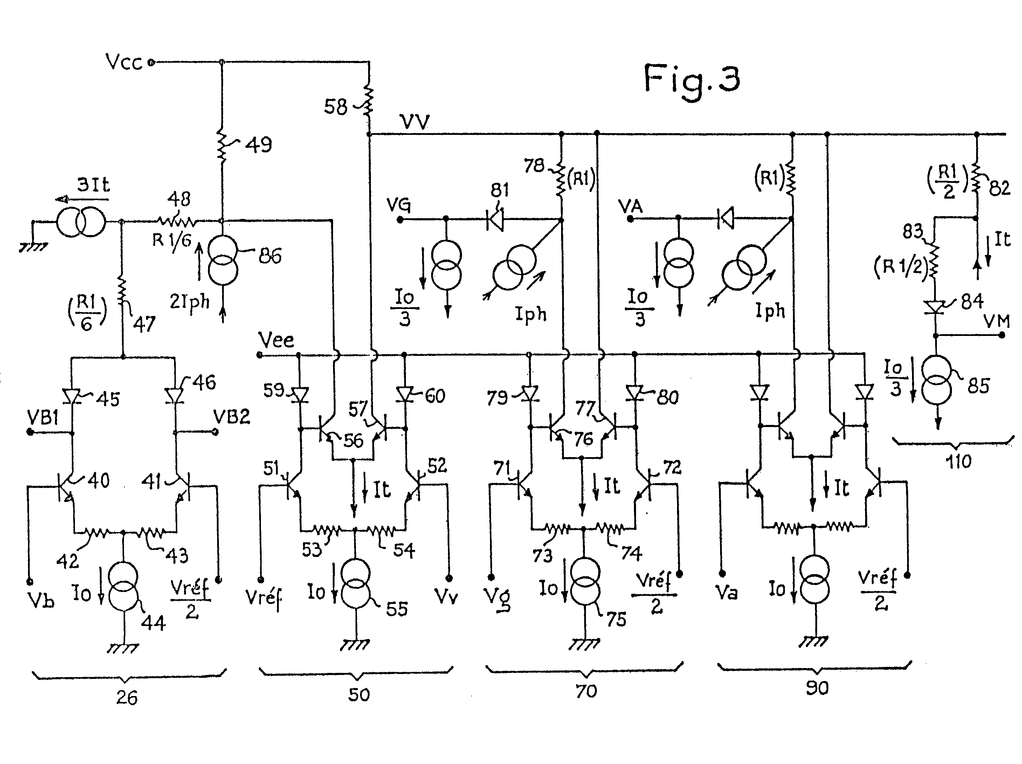

Un exemple de circuit de commande 30 permettant d'atteindre ce résultat est représenté en partie à la fig. 3, le circuit d'équilibrage 26 apparaissant aussi sur cette figure.

Le circuit d'équilibrage 26 comprend essentiellement un amplificateur différentiel à deux transistors 40 et 41, l'un d'eux étant attaqué sur sa base par la tension Vb issue du potentiomètre à curseur (d'équilibrage) 28 (fig. 2), et l'autre recevant sur sa base une tension fixe Vréf/2 définissant une position d'équilibrage théorique des deux voies stéréophoniques. Les transistors ont des résistances d'émetteur 42 et 43 respectivement qui sont toutes deux connectées à une source de courant 44 établissant, dans cet amplificateur différentiel, un courant global constant Io se répartissant entre les deux transistors 40 et 41 en fonction de la différence de potentiel Vb − Vréf/2.

Les sorties du circuit d'équilibrage sont prises sur les collecteurs de chacun des transistors, sur lesquels apparaissent les tensions variables VB1 et VB2 servant de références variables à chacune des deux voies stéréophoniques.

Les collecteurs des transistors sont reliés par l'intermédiaire de diodes respectives 45 et 46 à un point commun qui lui-même est relié à une tension d'alimentation fixe Vcc par l'intermédiaire d'un ensemble de résistances en série 47, 48 et 49. Les diodes 45 et 46 ont pour fonction de donner à l'amplificateur différentiel une courbe de réponse logarithmique. Combinée à des potentiomètres électroniques à fonction exponentielle, on obtient ainsi une variation linéaire de répartition des puissances en fonction du réglage de l'équilibrage des voies. D'autres détails du circuit d'équilibrage 26 seront donnés dans la suite de la description.

Le circuit de commande 30 se divise en quatre parties qui sont:

— un atténuateur différentiel 50 recevant la tension de référence Vréf et la tension Vv issue du potentiomètre à curseur 36 définissant le réglage du volume sonore; cet atténuateur fournit une tension VV variable en fonction du réglage du volume sonore; cette tension servira de variable commune pour moduler les tensions VA, VM et VG lorsque l'on fera varier le volume sonore;

— un atténuateur différentiel 70 recevant une tension de référence Vréf/2 et la tension Vg issue du potentiomètre à curseur 32 de réglage des graves; cet atténuateur est alimenté par la tension VV et non par une tension fixe et fournit à sa sortie la tension VG proportionnelle à VV et fonction (en général linéaire) de Vg − Vréf/2; cette tension VG sert à la commande du potentiomètre électronique 24 de la voie grave;

— un atténuateur différentiel 90 identique à l'atténuateur 70 mais recevant Vréf/2 d'une part et Va (issu du réglage des aigus); cet atténuateur est aussi alimenté par VV et fournit à sa sortie la tension VA proportionnelle à VV et fonction (en général linéaire) de Va − Vréf/2; cette tension VA sert à la commande du potentiomètre électronique 20 de la voie aiguë;

— un atténuateur simple 110 recevant la tension VV et établissant une tension VM essentiellement proportionnelle à VV; cette tension VM sert à la commande du potentiomètre électronique 22 de la voie médium.

L'atténuateur différentiel 50, alimenté par une polarisation fixe Vcc comprend deux transistors 51 et 52 dont les bases reçoivent respectivement Vréf et Vv. Les émetteurs sont reliés par des résistances 53 et 54 à une source de courant 55 qui fait passer un courant constant Io qui se divise dans les deux transistors selon la valeur de Vréf − Vv.

Les collecteurs des transistors 51 et 52 sont reliés respectivement aux bases de deux transistors 56 et 57 ayant leurs émetteurs reliés à une source de courant non représentée fournissant un courant It proportionnel à la température absolue. La production du courant It, classique, n'est pas représentée. Les transistors 56 et 57 forment un étage de compensation de température et jouent en même temps le rôle d'inverseurs. La sortie de l'étage différentiel 50 est prise sur le collecteur du transistor 57 qui est relié à Vcc par une résistance 58 servant de charge. La tension de sortie VV, fonction de Vréf − Vv, apparaît sur ce collecteur. Le collecteur du transistor 56 est relié au point de jonction de la résistance 49 et de la résistance 48 mentionnées lors de la description du circuit d'équilibrage 26. La résistance 49 et la résistance 58 ont même valeur pour assurer qu'une modification de la température (variation de It) n'influe pas sur le réglage du niveau sonore. On s'arrange pour que les résistances 49 et 58 soient parcourues par le même courant 3 × It produit par une source de courant non représentée, recopiant, en le multipliant, le courant It.

Des diodes 59 et 60 reliant les collecteurs des transistors 51 et 52 à une tension de polarisation Vee inférieure à Vcc rétablissent la linéarité de la tension de sortie de l'atténuateur (tension VV) en fonction de la différence Vv − Vréf.

L'atténuateur différentiel 50 est donc alimenté par une tension fixe Vcc et produit une tension variable VV qui sert à alimenter les autres atténuateurs 70, 90 et 110.

Les atténuateurs 70 et 90 sont rigoureusement identiques. On ne décrira donc que le premier. Il ressemble d'ailleurs beaucoup à l'atténuateur différentiel 50. Il comprend deux transistors 71 et 72 recevant sur leurs bases respectivement la tension Vg issue du bouton de réglage des graves (Va issue du bouton de réglage des aigus pour l'atténuateur différentiel 90), et une tension de référence Vréf/2.

Les émetteurs des transistors 71 et 72 sont reliés, par des résistances d'émetteurs respectives 73 et 74, à une source de courant 75 fournissant un courant constant Io d'alimentation des deux branches de l'atténuateur différentiel.

Des transistors 76 et 77, dont les bases sont reliées aux collecteurs des transistors 71 et 72, servent d'inverseurs et d'étage de compensation en température. Leurs émetteurs sont reliés à une source de courant fournissant un courant It proportionnel à la température absolue.

Les courants Io et It mentionnés en relation avec l'atténuateur 70 sont en principe les mêmes que ceux mentionnés à propos de l'atténuateur 50. Ils sont engendrés par une source de courant commune et des transistors de recopie non représentés.

Des diodes 79 et 80 sont reliées entre le potentiel Vee et les collecteurs des transistors 71 et 72 pour lesquels elles servent de charge. Le collecteur du transistor 17 est relié au potentiel VV.

La sortie de l'atténuateur différentiel 70 se fait sur le collecteur du transistor 76 qui est relié au potentiel VV par l'intermédiaire d'une résistance de charge 78. Sur cette sortie apparaît un potentiel fonction linéaire (d'après le montage choisi) de Vg − Vréf/2 et proportionnel à VV, donc fonction de la position du bouton de réglage de volume.

Toutefois, la sortie effective de l'étage, sur laquelle apparaît le potentiel VG qui servira à la commande de potentiomètre électronique de la voie grave, est prise après une diode 81 reliée au collecteur du transistor 76 et à une source de courant d'amplitude Io/3. Cette diode 81 a pour fonction de compenser la chute de tension créée par les diodes de l'étage d'équilibrage 26 afin que, lorsque l'on est dans l'état où les voies sont théoriquement équilibrées (VB1 − VB2), où le volume est au maximum et les boutons de réglage des graves et des aigus sont à mi-course et fournissent des tensions Vg − Va = Vréf/2, on ait bien :

$$VG − VB1 = 0 = VA − VB1 = VG − VB2 = VA − VB2,$$ sans que les diodes 45 et 46 décalent de 0,7 V ces égalités.

On notera que les résistances 78, 47 et 48 sont dans des rapports précis pour que cette condition soit réalisée. Il faut en particulier prévoir, dans l'exemple représenté, que, si R1 est la valeur de la résistance 78, les résistances 47 et 48 doivent alors avoir une valeur de R1/6 chacune.

Pour assurer la correction physiologique selon l'invention, un courant Iph est injecté au point de jonction entre la résistance 78 et le collecteur du transistor 76. Autrement dit, une partie du courant traversant le transistor 76 ne traverse pas la résistance de charge 78 de l'étage différentiel 70. Comme le courant dans le transistor 76 est déterminé par la valeur du potentiel Vg, le potentiel du point de jonction entre la résistance 78 et le collecteur du transistor 76 chute d'autant moins que le courant Iph injecté est plus grand. VG est donc directement influencé par le courant Iph.

On s'arrange, selon l'invention, pour établir un courant Iph d'autant plus important que le réglage du bouton de volume est plus faible.

L'atténuateur différentiel 90, servant à la production d'une tension de commande du potentiomètre électronique de la voie aiguë à partir de la tension Va de réglage de tonalité aiguë, est identique à l'atténuateur différentiel 70, y compris pour la présence d'une injection de courant Iph. On notera qu'en principe ce courant Iph a la même valeur pour la voie aiguë dans l'atténuateur 90 que pour la voie grave (dans l'atténuateur 70). Toutefois, on pourrait prévoir des courants différents si on souhaite que ce relèvement des fréquences basses ne soit pas égal au relèvement des fréquences aiguës lors de la diminution du réglage de volume.

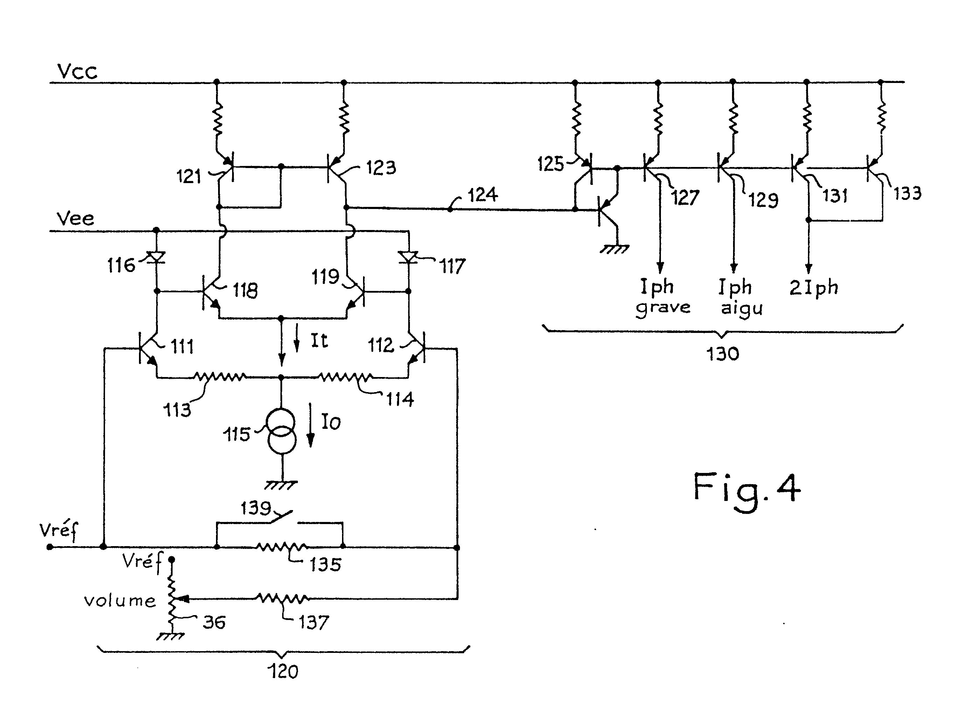

On décrira, en référence à la fig. 4, une manière possible de produire le courant Iph.

A propos de la fig. 3, il reste à décrire l'atténuateur 110 de la voie médium. Dans l'exemple décrit, il s'agit d'un atténuateur très simple, qui comprend un pont diviseur avec deux résistances en série 82 et 83 qui ont de préférence des valeurs R1/2 chacune, si R1 est la valeur des résistances de charge 78 des atténuateurs 70 et 90.

Les résistances 82 et 83 sont alimentées par la tension VV issue de l'atténuateur différentiel 50 (tension fonction de réglage du volume sonore). Elles sont en série avec une diode 84 (qui, comme la diode 81, compense la chute de tension introduite par les diodes 45 et 46 du circuit d'équilibrage), et avec une source de courant 85, de valeur Io/3, qui impose le passage dans les résistances 82 et 83 d'un courant Io/3. De plus, un courant It, proportionnel à la température absolue, est prélevé depuis le point de jonction entre les résistances 82 et 83, de sorte qu'en fait la résistance 82 est parcourue par Io/3+It et permet une compensation en température de la voie médium comme des autres voies.

La sortie de l'étage atténuateur 110, délivrant une tension VM de commande du potentiomètre électronique de la voie médium, est prise en aval de la diode 84, au point de jonction entre celle-ci et la source de courant 85.

Aucune injection de courant Iph n'est effectuée dans l'étage 110, de sorte que c'est seulement sur les graves et les aigus qu'agit le courant de correction Iph, réalisant bien ainsi l'effet physiologique désiré.

Si l'on souhaite que la correction physiologique puisse être éliminée par une touche qui annule le courant Iph, et si l'on veut que la suppression de la correction physiologique laisse les médiums essentiellement inchangés, il faut prévoir que non seulement la tension VM mais aussi les tensions VB1 et VB2 soient inchangées lors de la suppression de la correction. Or, la suppression de Iph à deux endroits (atténuateurs 70 et 90) modifie VV (par l'intermédiaire de la résistance 58), donc modifie d'autant VM. On compense ce phénomène en modifiant de la même manière VB1 et VB2 pour que les différences VM−VB1 et VM−VB2 ne bougent pas. Pour cela, on injecte, au point de jonction de la résistance 49 (qui a même valeur que la résistance 58) et du collecteur du transistor 56, un courant 2×Iph, par une source de courant 86 réalisée par une recopie (avec multiplication par deux) du courant Iph. Si on ne veut pas garder constant le niveau des médiums, on peut éviter cette source de courant 2×Iph ou prévoir une source d'une autre valeur en fonction de l'effet désiré.

Le circuit destiné à la production des courants de correction physiologique Iph, qui fait partie du circuit de commande 30, est représenté à la fig. 4.

Il comprend essentiellement un étage amplificateur différentiel 120, dont l'entrée est une différence de potentiel et la sortie est une sortie de courant variant dans le même sens que la différence de potentiel d'entrée, et des étages de recopie de courant regroupés sous la référence 130. Ces derniers recopient, éventuellement avec un coefficient multiplicateur choisi, le courant de sortie de l'étage différentiel 120, et appliquent ce courant aux points indiqués au niveau des sorties des atténuateurs 70 et 90.

L'étage différentiel 120 est par exemple constitué comme l'étage 70, alimenté par une tension de polarisation fixe Vee (la même qu'à la fig. 3) et par la tension fixe Vcc au lieu de la tension VV. L'étage comprend essentiellement deux transistors 111 et 112 dont les émetteurs sont reliés par des résistances 113 et 114 à une source de courant 115 fournissant un courant Io. Des diodes 116 et 117 reliées à la tension Vee servent de charge aux collecteurs des transistors. Des transistors 118 et 119 alimentés en parallèle par un courant It jouent le rôle d'inverseurs et de compensation de la température, et les courants passant dans ces transistors sont directement dépendants de la différence de potentiel appliquée entre les bases des transistors 111 et 112. Les charges des transistors 118 et 119 reliées à la tension Vcc sont constituées par deux transistors respectifs 121 et 123, le transistor 123 étant monté de manière à recopier le courant du transistor 121. La sortie 124 de l'étage différentiel est prise sur le collecteur du transistor 119.

Si l'étage différentiel 120 est équilibré (différence de potentiel nulle entre les bases des transistors 111 et 112), les courants dans les collecteurs des transistors 118 et 119 sont les mêmes, ce qui correspond bien au fait que les charges (transistors 121 et 123) sont parcourues par le même courant (l'un recopiant l'autre). Le courant de sortie de l'étage est alors nul.

Si l'étage différentiel 120 est déséquilibré, les courants dans les transistors 118 et 119 sont différents, mais les courants dans leurs charges sont identiques puisque le transistor 123 recopie le courant du transistor 121. La différence est donc absorbée sur la sortie 124 de l'étage différentiel. Ce courant différentiel de sortie passe dans un transistor 125 et est recopié dans les étages de recopie 130, respectivement par un transistor 127 pour produire le courant Iph destiné à l'étage 70, par un transistor 129 pour produire le courant Iph destiné à l'étage 90, et par deux transistors 131 et 133 en parallèle, de même taille que les transistors 127 et 129, pour produire le courant 2×Iph qu'on a mentionné à propos de la fig. 3.

On peut noter que, si les transistors 127 et 129 sont choisis différents, on peut produire une correction de fréquence différente pour les voies grave et aiguë.

Pour terminer la description du circuit de la fig. 4, il faut encore indiquer que la différence de potentiel appliquée aux bases des transistors 111 et 112 doit être fonction directe des variations du réglage du volume sonore pour que la correction de fréquences corresponde bien à l'effet recherché en fonction du volume sonore.

Pour cela, on peut prévoir que la base du transistor 111 est reliée à la tension de référence Vréf et la base de l'autre transistor 112 reliée au point milieu d'un pont diviseur comprenant deux résistances 135 et 137 qui sont en série et dont l'une est reliée à Vréf et l'autre au curseur du potentiomètre à curseur 36 servant au réglage du volume sonore. La résistance 135, qui relie donc les bases des deux transistors 111 et 112, peut être court-circuitée par un interrupteur 139 pour mettre hors service la correction physiologique.

De la valeur de la résistance 137 dépend l'amplitude de l'effet de correction physiologique. On peut prévoir qu'elle ne fait pas partie du circuit intégré comprenant l'ensemble du circuit de commande 30 afin de pouvoir la modifier ou la choisir en fonction de l'application. On réalise ainsi une sorte de programmation de l'effet physiologique désiré. On peut aussi prévoir que la résistance est ajustable à volonté par l'utilisateur, sous la forme d'un potentiomètre.

On a ainsi décrit en détail une réalisation de l'ensemble du circuit permettant d'atteindre le résultat recherché de correction physiologique de la courbe de réponse d'un amplificateur en audiofréquences.

D'autres solutions pratiques peuvent être imaginées à partir des indications données dans la description qui précède, sans sortir du cadre de l'invention.

Par exemple, on peut prévoir que la correction physiologique n'intervient qu'au-dessous d'un réglage de volume sonore donné, tandis qu'elle n'intervient plus au-dessus. Il suffit pour cela de relier la base du transistor 111 de la fig. 4 à une tension qui n'est pas Vréf, mais une fraction de Vréf (prélevée par exemple sur une prise fixe du potentiomètre 36 de réglage de volume).

On peut aussi prévoir que la correction physiologique s'effectue non pas grâce à l'injection de deux courants Iph aux sorties des atténuateurs 70 et 90 (grave et aigu) pour relever les graves et les aigus, mais au contraire grâce à l'injection d'un courant de sens opposé à la sortie de l'atténuateur 110 correspondant à la commande du potentiomètre électronique de la voie médium, afin de réduire les fréquences médiums proportionnellement à la réduction de volume sonore. Il n'en résulte que des modifications mineures du schéma de la fig. 3.

**Revendications**

1. Circuit de filtrage réalisant la commande de volume et de tonalité d'un amplificateur de fréquences sonores, comprenant un bouton de réglage de volume sonore (36), au moins un bouton de réglage de tonalité (32, 34), trois ensembles en parallèle d'un potentiomètre électronique et d'un filtre (10, 20; 12, 22; 14, 24) constituant trois voies de signal, respectivement aiguë, médium et grave, et un circuit de commande (30) apte à produire des tensions de commande du gain de chacun des potentiomètres électroniques en fonction de la position des boutons de réglage, de manière que les tensions de commande (VA, VM, VG) varient toutes trois simultanément dans le même sens lorsque le bouton de volume est actionné, et qu'elles varient différemment selon l'actionnement du bouton de réglage de tonalité, caractérisé par le fait que le circuit de commande est agencé pour produire des tensions de commande de gain telles que la variation du gain du potentiomètre électronique de la voie grave (24) et celle du gain de la voie aiguë (20) résultant de l'actionnement du bouton de volume soit inférieure à la variation du gain de la voie médium (22), au moins dans une partie de la plage de réglage du volume sonore.

2. Circuit selon la revendication 1, caractérisé par le fait que, aux environs du réglage du volume sonore maximal, la variation de gain en fonction de l'actionnement du bouton de volume est sensiblement la même pour les trois voies.

3. Circuit de filtrage selon la revendication 2, caractérisé par le fait qu'il comprend un atténuateur (50) recevant une tension issue du bouton de réglage de volume et produisant une tension variant dans le même sens que le volume et servant, d'une part, à établir une tension de commande de gain du potentiomètre électronique de la voie médium et, d'autre part, à alimenter deux autres atténuateurs (70, 90) recevant respectivement deux tensions issues du (ou des) bouton(s) de commande de tonalité, avec en outre un étage de production d'un courant de correction (Iph) lié à la position du bouton de réglage de volume, et un moyen pour combiner la tension de sortie de chacun des deux autres atténuateurs avec le courant de correction physiologique et produire ainsi deux tensions de commande (VA, VG) modifiées par le courant de correction et destinées à la commande des potentiomètres électroniques des voies grave et aiguë, la combinaison du courant et de la tension étant telle que la variation du gain des voies grave et aiguë lorsqu'on varie le volume sonore est moins forte que la variation du gain de la voie médium.

4. Circuit selon la revendication 3, caractérisé par le fait que l'étage de production d'un courant de correction physiologique comprend un amplificateur différentiel (120) dont une entrée reçoit une tension de référence et l'autre une tension issue du bouton de réglage de volume sonore, et dont la sortie fournit un courant fonction de la différence des tensions d'entrée, un étage (130) de recopie de ce courant étant prévu pour fournir un courant de correction de la tension de commande des potentiomètres électroniques des voies grave et aiguë.

5. Circuit selon la revendication 4, caractérisé par le fait que l'amplificateur différentiel de l'étage de production d'un courant de correction physiologique comporte deux branches différentielles avec, dans chacune, un transistor de charge dont l'un recopie le courant de l'autre, la sortie délivrant un courant fonction du déséquilibre de l'amplificateur différentiel.

## Patentansprüche

1. Filterschaltung zur Klang- und Tonregelung bei einem Tonfrequenzverstärker, mit einem Lautstärkeeinstellknopf (36), wenigstens einem Klangregelknopf (32, 34), drei parallelgeschalteten elektronischen Potentiometereinheiten und einem Filter (10, 20; 12, 22; 14, 24), die drei Signalwege bilden, nämlich für hohe, mittlere und tiefe Töne, sowie mit einer Steuerschaltung (30) zur Erzeugung von Verstärkungssteuerspannungen für jedes der elektronischen Potentiometer in Abhängigkeit von der Stellung der Einstellknöpfe, dergestalt, dass die Steuerspannungen (VA, VM, VG) alle drei gleichzeitig in demselben Sinne verändert werden, wenn der Lautstärkeeinstellknopf betätigt wird, und dass sie je nach Betätigung des Klangregelknopfes unterschiedlich verändert werden, dadurch gekennzeichnet, dass die Steuerschaltung ausgelegt ist, um derartige Verstärkungssteuerspannungen zu erzeugen, dass die Änderung des Verstärkungfaktors des elektronischen Potentiometers des Tieftonkanals (24) sowie des Hochtonkanals (20), welche aus der Betätigung des Lautstärkeknopfes resultieren, kleiner ist als die Änderung des Verstärkungsfaktors für den Mitteltonkanal (22), und zwar wenigstens in einem Teil des Lautstärkeeinstellbereichs.

2. Schaltung nach Anspruch 1, dadurch gekennzeichnet, dass im Einstellbereich maximaler Lautstärke die Änderung des Verstärkungsfaktors in Abhängigkeit von der Betätigung des Lautstärkeknopfes für die drei Kanäle im wesentlichen dieselbe ist.

3. Filterschaltung nach Anspruch 2, dadurch gekennzeichnet, dass sie ein Dämpfungsglied (50) umfasst, welches eine von dem Lautstärkeeinstellknopf abgegebene Spannung empfängt und eine Spannung erzeugt, die im selben Sinne wie die Lautstärke verändert wird und dazu dient, einerseits eine Spannung zur Verstärkungssteuerung des elektronischen Potentiometers für den Mitteltonkanal zu erzeugen und andrerseits zwei weitere Dämpfungsglieder (70, 90) zu speisen, die jeweils eine von zwei Spannungen empfangen, welche von dem Klangregelknopf bzw. von den Klangregelknöpfen abgegeben werden, ferner mit einer Stufe zur Erzeugung eines Korrekturstromes (Iph), der von der Stellung des Lautsärkeeinstellknopfes abhängt, und mit einer Einrichtung zum Kombinieren der Ausgangsspannung jedes der beiden weiteren Dämpfungsglieder mit dem physiologischen Korrekturstrom, um auf diese Weise zwei Steuerspannungen (VA, VG) zu erzeugen, die durch den Korrekturstrom verändert und dazu bestimmt sind, die elektronischen Potentiometer für den Tieftonkanal und für den Hochtonkanal zu steuern, wobei die Kombination des Stromes mit der Spannung derart ist, dass die Änderung des Verstärkungsfaktors für den Tieftonkanal und den Hochtonkanal, wenn die Lautstärke verändert wird, weniger stark ist als die Änderung des Verstärkungsfaktors für den Mitteltonkanal.

4. Schaltung nach Anspruch 3, dadurch gekennzeichnet, dass die Stufe zur Erzeugung eines physiologischen Korrekturstromes einen Differenzverstärker (20) umfasst, wovon ein Eingang eine Referenzspannung und der andere eine Spannung empfängt, die von dem Lautstärkeeinstellknopf abgegeben wird, und dessen Ausgang einen Strom abgibt, welcher von der Differenz der Eingangsspannungen abhängt, wobei eine Stufe (130) zur Nachbildung dieses Stromes vorgesehen ist, um einen Korrekturstrom zur Korrektur der Steuerspannung für die elektronischen Patentiometer des Tieftonkanals und des Hochtonkanals zu liefern.

5. Schaltung nach Anspruch 4, dadurch gekennzeichnet, dass der Differenzverstärker der Stufe zur Erzeugung des physiologischen Korrekturstromes zwei differentielle Zweige umfasst, worin jeweils ein Lasttransistor vorgesehen ist, von denen der eine den Strom des anderen nachbildet, während der Ausgang einen Strom abgibt, der von dem Ungleichgewicht des Differenzverstärkers anhängt.

## Claims

1. Filter circuit performing the volume and tone control of an audio frequency amplifier, comprising a volume adjustment button (36), at least one tone adjustment button (32, 34), three parallel electronic potentiometer units and a filter (10, 20; 12, 22; 14, 24) forming three signal paths for treble, medium and bass, respectively, and a control circuit (30) for producing gain control voltages for each of the electronic potentiometers in function of the positions of the adjustment buttons, in such a manner that the control voltages (VA, VM, VG) vary simultaneously in the same sense when the volume button is operated, and vary differently in accordance with the operation of the tone and adjustment button, characterized by the fact that the control circuit is adapted to produce gain control voltages such that the gain variation of the electronic potentiometer of the bass channel (24) and that of the gain of the treble channel (20) resulting from actuation of the volume button is less than the gain variation of the medium channel (22) at least within part of the volume adjustment range.

2. Circuit according to Claim 1, characterized by the fact that in the neighborhood of the maximum volume adjustment the gain variation depending on the actuation of the volume button is substantially the same for the three channels.

3. Filter circuit according to Claim 2, characterized by the fact that it comprises an attenuator (50) receiving a voltage derived from the volume adjustment button and producing a voltage varying in the same sense as the volume and used, on the one hand, for establishing a gain control voltage of the electronic potentiometer of the medium channel and, on the other hand, to feed two further attenuators (70, 90) respectively receiving two voltages derived from the tone control button(s), and further with a stage for producing a correction current (Iph) related to the position of the volume adjustment button and means for combining the output voltage of each of the two further attenuators with the physiological correction current and thus combining two control voltages (VA, VG) modified by the correction current and provided for the control of the electronic potentiometers of the bass and treble channels, the combination of the current and of the coltage being such that the gain variation of the bass and treble channels upon variation of the volume is less than the gain variation of the medium channel.

4. Circuit according to Claim 3, characterized by the fact that the stage for producing a physiological correction current comprises a differential amplifier (120) one input of which receives a reference voltage and the other a voltage derived from the volume adjustment button, and the output of which supplies a current depending on the difference between the input voltages, a stage (130) for copying this current being provided to supply a correction current for correcting the control voltage of the electronic potentiometers of the bass and treble channels.

5. Circuit according to Claim 4, characterized by the fact that the differential amplifier of the stage for producing a physiological connection current comprises two differential branches each having a load transistor one of which copies the current of the other, the output supplying a current depending on the unbalance of the differential amplifier.

Fig.1

Vcc

VA
commande
VB

T1

entrée

T2

sortie

Fig.2

10 — aigu

12 — médium

14 — grave

sortie
voie 1

VB1

VB1

VB1

20

22

24

signal voie 1

voie 1

VA

VM

VG

vers voie 2

30

circuit de commande

Vv

Vg

Va

26 — équilibrage

VB1

VB2

vers voie 2

Vb

volume

36

Vréf

graves

32

Vréf

aigus

34

Vréf

balance

28

Vréf

Fig.3

Fig.4

15

0 060 188